# EUROPEAN PATENT SPECIFICATION

(11) **EP 1 926 358 B1**
(45) Date of publication and mention of the grant of the patent: **02.11.2011**
(21) Application number: 06810048.6
(22) Date of filing: 08.09.2006
(51) Int. Cl.: H05K 3/18, B29C 69/00, H05K 3/00

(54) **MOLDING CIRCUIT COMPONENT AND PROCESS FOR PRODUCING THE SAME**
SCHALTUNGSBESTANDTEILE UND HERSTELLUNGSVERFAHREN DAFÜR
COMPOSANT DE CIRCUIT DE MOULAGE ET PROCEDE DE FABRICATION IDOINE

(30) Priority: 12.09.2005 JP 2005264336
(43) Date of publication of application: 28.05.2008
(73) Proprietor: SANKYO KASEI CO., LTD., Ohta-ku Tokyo Tokyo 146 0085 (JP)
(72) Inventor: YOSHIZAWA, Norio, Tokyo 1350016 (JP); WATANABE, Hiroaki, Tokyo 1240011 (JP)
(74) Representative: Schwabe - Sandmair - Marx
(86) International application number: PCT/JP2006/317813
(87) International publication number: WO 2007/032260

(56) References cited:
- JP-A- 8 064 933
- JP-A- 08 064 933
- JP-A- 10 190 193
- JP-A- 10 190 193
- JP-A- 2001 077 512
- JP-A- 2001 077 512
- JP-A- 2001 244 610
- JP-A- 2001 244 610

## Description

### Technical Field

The present invention relates to a molded circuit component and a process for producing the same, the molded circuit component being used for, for example, connectors for cellular telephones having a circuit formed by plating a portion of the surface or the inner circumference of through holes of the component.

### Background Art

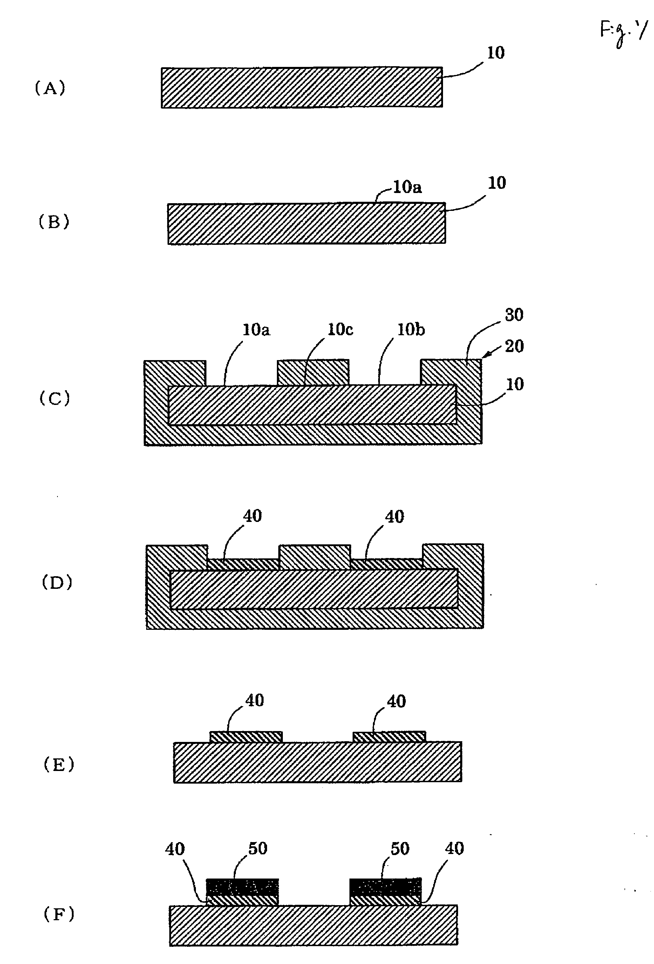

The inventors of the present invention have previously proposed a process for producing the molded circuit component shown in Figs. 7 to 9. In the production process, as shown in Fig. 7(A), a thermoplastic material is inj ection-molded to form a primary substrate 10 which is an electric insulating body having a predetermined shape, and the circuit is formed on it. A conductive layer 50, namely a circuit, is formed on the upper surface of the primary substrate 10 (see Fig. 7(F)), which surface is on the same level as the other surface not to have any circuit (non-circuit forming area). The thermoplastic material is a liquid crystal polymer of plating grade, for example, aromaticpolymers such as "VECTRAC810" (tradename, manufactured by Polyplastic Co., Ltd.) of plating grade.

Subsequently, as shown in Fig. 7(B), the primary substrate 10 is roughened all over to form a rough surface 10a. For the roughening treatment, the primary substrate is degreased, and the surface thereof is etched. The etching treatment is conducted, for example, by immersing the primary substrate 10 in an aqueous alkaline solution containing 45 wt% caustic soda or caustic potash for 30 minutes. The aqueous alkaline solution is heated to predetermined temperature of 50 to 90°C. By the etching treatment, the primary substrate can be roughened all over to form the rough surface 10a.

Subsequently, as shown in Fig. 7(C), in order to form a secondary substrate 20, a resin mask 30 is molded to be integral with the primary substrate 10 in such a manner that a circuit forming area 10b on the primary substrate 10 to be formed a conductive layer of a specific circuit pattern is exposed, and other area of a non-circuit forming area 10c is covered by the resin mask 30. Specifically, the secondary substrate 20 is formed by injecting the material of the resin mask, for example an oxyalkylene group-containing polyvinyl alchohol resin, into the cavity of the ordinary die which is formed with an upper body and a lower body, accommodating the primary substrate 10 with a predetermined gap on the non-circuit forming area, and with close contact on the circuit forming area. Examples of the oxyalkylene group-containing polyvinyl alcohol resin include "ECOMATY AX" (trade name, manufactured by Nippon Synthetic Chemical Industry Co., Ltd.). Examples of the material of the resin mask 30 include, in addition to polyvinyl alcohol resins as described above, biodegradable resins such as polylactic acid, succinic acid, cellulose, starch,butyric acid, and glycol resins, and organic acid-soluble polyamide resins.

Then, as shown in Fig. 7(D), a catalyst 40 for electroless plating is applied to the exposed area on the secondary substrate 20 that is a circuit forming area 10b where a conductive layer is applied. The catalyst 40 is applied by a known process. For example, the secondary substrate 20 is immersed in a mixed catalyst solution containing tin and palladium, and then activated by an acid such as sulfuric acid or hydrochloric acid to deposit palladium on the surface of the substrate. Alternatively, a relatively strong reducing agent such as stannous chloride is adsorbed to the surface of the substrate, and then the substrate is immersed in a catalyst solution containing precious metal ions such as gold to deposit gold on the surface of the substrate. The temperature of the catalyst solution is from 15 to 23°C, and the immersion time is 5 minutes.

Subsequently, as shown in Fig. 7(E), after the application of the catalyst 40, the resin mask 30 on the secondary substrate 20 is removed. In cases where the resin mask 30 is molded of "ECOMATY AX", the secondary substrate 20 is heated in hot water thereby eluting the resin mask 30 into the hot water. By immersing the secondary substrate 20 in hot water having a temperature of about 80°C for about 10 minutes, the resin mask 30 made of "ECOMATY AX" is readily eluted. However, the primary substrate 10 will not be affected, because it is made of "VECTRA C810" of plating grade having a heat deformation temperature of 200°C or more.

Finally, as shown in Fig. 7(F), the portion having the catalyst 40, or the circuit forming area 10b is subjected to electroless plating such as chemical copper plating or chemical nickel plating thereby forming a conductive layer 50. (Japanese Patent No. 3616488).

### Disclosure of the Invention

### Problems to be Solved by the Invention

In the conventional example shown in Fig. 7, in the step of removing the resin mask 30 after the formation of the mask as shown in Fig. 7(D), in cases where the circuit forming area 10b is on the same level as the non-circuit forming area 10c (non-circuit area) on the primary substrate 10 as shown in Fig. 7(F), the material of the primary substrate must be highly compatible with the material of the resin mask 30 of the secondary substrate 20. In addition, the non-circuit forming area must have a large width, and the material properties of the primary substrate 10 required by the applications of the final product including the molded circuit component, that is, high frequency properties are incompatible with the material of the resin mask 30. Therefore, applications of the component are limited.

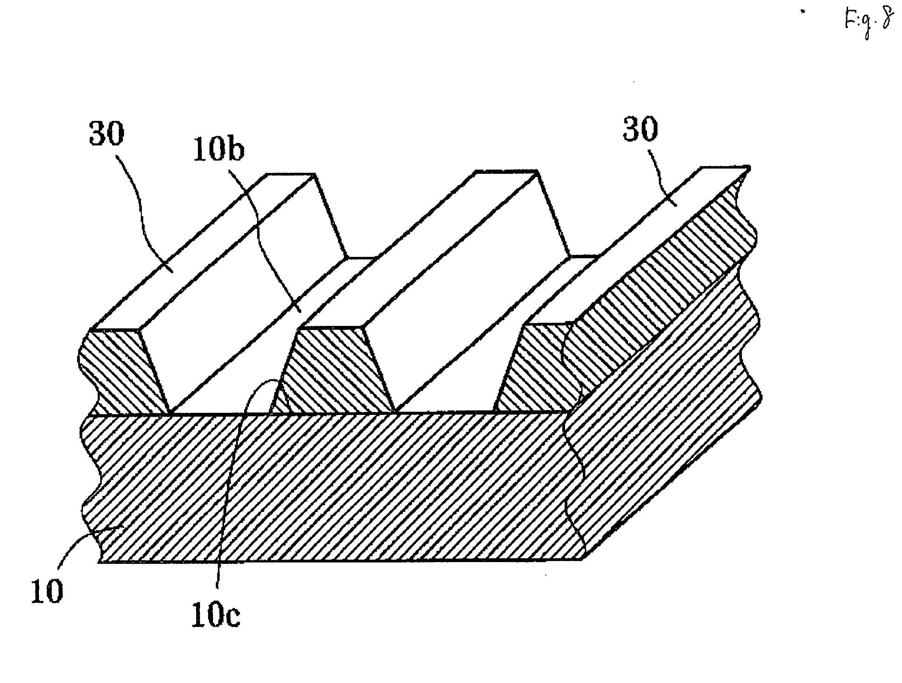

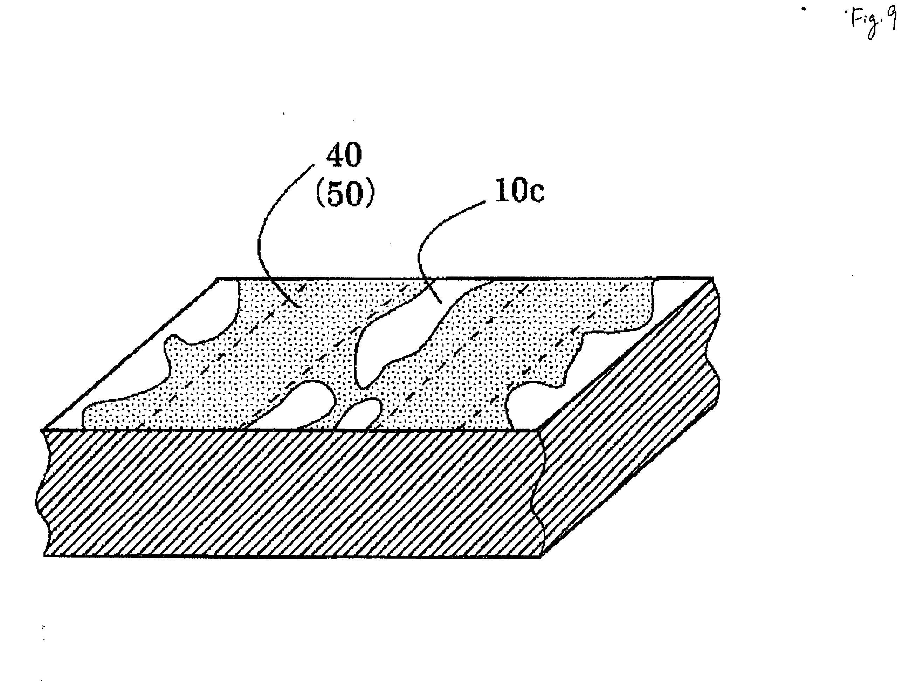

For example, in consideration of the compatibility of the material of the primary substrate 10 to the material of the secondary substrate 20, it is often difficult to choose a material of the resin mask 30 of the secondary substrate 20 to be highly compatible with the material of the primary substrate 10 having high frequency properties and dielectric constant. In practice, it is often impossible to choose a highly compatible material. In the case when the compatibility is poor, even though the resin mask 30 is formed as shown in Fig. 8 and Fig. 7(C) in such a manner that the circuit forming area 10b on the roughened primary substrate 10 is exposed, and the other area, namely the non-circuit forming area 10c is covered by the resin mask 30, the catalyst solution penetrates as shown in Figs. 9 and 7(D), into the non-circuit forming area 10c covered by the resin mask 30, during immersion in the catalyst solution for electroless plating, which results in deposition of plating to cause shorting problem between circuits, and deterioration of the yield.

In order to prevent such shorting problembetween circuits, in a conventional method, the width of the non-circuit forming area 10c has been expanded. However, as will be described later, in recent years, it is increasingly required to decrease the space between wiring of the circuits, for example, to 200 µm. Under such present situation, it is very difficult to expand the width of the non-circuit forming area 10c.

JP-A-10190193 discloses a circuit board where conductor plate patterns formed on a resin board are prevented form short circuiting with each other by molding the primary substrate to have two different levels.

Accordingly, the present invention is intended to provide a process for producing a molded circuit component, whereby the above-described problems are solved without any significant changes of the shape of the primary substrate but only by providing an arrangement as defined by the features of the appended claims, which expands the range of options to choose the material of the primary substrate and the material of the resin mask of the secondary substrate, more specifically, allows the use of poorly compatible materials, thereby expanding the range of applications of the molded circuit component.

In recent years, as electronic equipment is required to implement energy saving, resource saving, and speedup of electron signals, and multibanded equipment, the decrease of the space between lines of a circuit pattern on a circuit board, and low dielectric loss tangent at high frequency are demanded. In addition, in order to downsize equipment with the intention of resource saving, from the viewpoints of increasing the density of lines and effectively using the space, three dimensional wiring and connections are preferred to two dimensional ones. The present invention properly copes with the above situation.

### Methods to Solve the Problems

The molded circuit component and the process for producing the same according to the present invention includes a level difference between the circuit forming area and the non-circuit forming area on the primary substrate. The level difference is preferably 0.05 mm or more.

The present invention also includes an dented or projecting level difference between the circuit forming area and the non-circuit forming area on the primary substrate, wherein the circuit forming area and the non-circuit forming area are connected by side walls having predetermined angle. The predetermined angle of the side walls connecting the circuit forming area and the non-circuit forming area is from 15° to 90°, preferably from 45° to 90°.

As described above, in the present invention, the level difference provided between the circuit forming area and the non-circuit forming area of the primary substrate decreases the osmotic pressure of the catalyst solution between the primary substrate and the resin mask, and the predetermined angle of the side walls connecting the circuit forming area and the non-circuit forming area decreases the osmotic pressure more effectively.

### Effect of the Invention

The present invention expands the range of options to choose the material of the primary substrate and the material of the resin mask on the secondary substrate without requiring significant change of the shape of the primary substrate, and reliably prevents shorting problem between circuits thereby expanding the range of applications of the molded circuit component.

### Brief Description of the Drawings

Fig. 1 is a perspective view of the secondary substrate of Example 1 composed of a resin mask and a primary substrate;
Fig. 2 is a perspective view of the secondary substrate of Example 1 after removal of the resin mask;
Fig. 3 is a perspective view of the secondary substrate of Example 1 for indicating the dimension;
Fig. 4 is a perspective view of the secondary substrate of Example 2 composed of a resin mask and a primary substrate;
Fig. 5 is a perspective view of the secondary substrate of Example 2 after removal of the resin mask;
Fig. 6 is a perspective view of the secondary substrate of Example 2 for indicating the dimension;
Figs. 7(A) to 7(F) are cross sectional views illustrating the manufacturing process of a conventional example;
Fig. 8 is a perspective view of the secondary substrate of a conventional example composed of a resin mask and a primary substrate; and
Fig. 9 is a perspective view of the secondary substrate of a conventional example after removal of the resin mask. Best Mode for Carrying Out the Invention

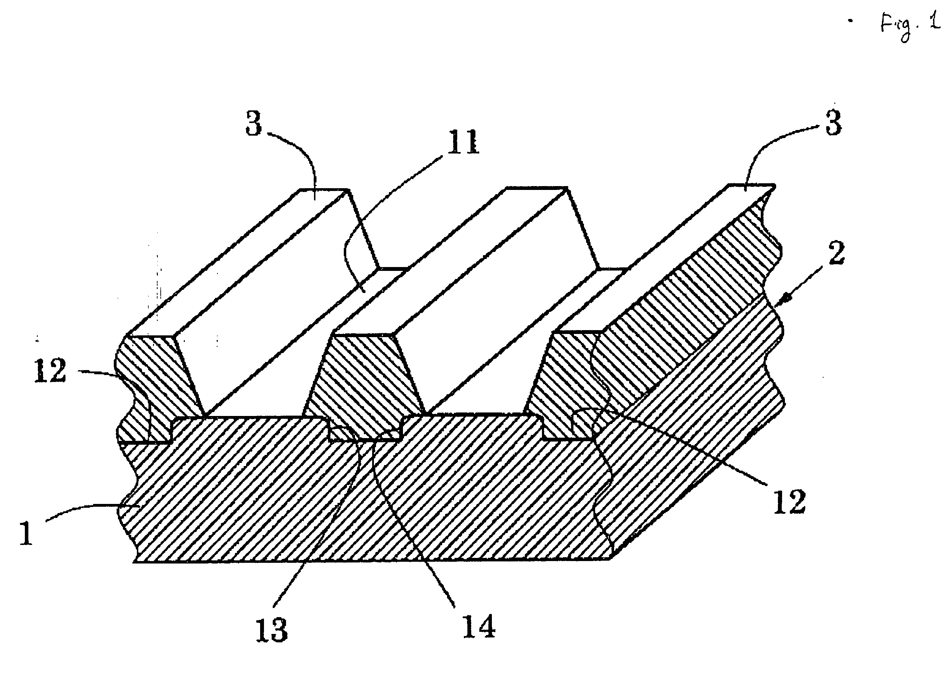

The best mode for carrying out the present invention is basically the modification of the conventional example shown in Fig. 7. Therefore, as shown in Figs. 1 to 3 and Fig. 7(A) of the conventional example, the production process begins with the step of injection molding of a thermoplastic material to mold a primary substrate 1 which is an insulating circuit forming body having a specified shape. The surface of the primary substrate is not flat. This is the most important feature of the present invention, so that details will be described later with reference to Figs. 1 to 3. The process also includes, as shown in Figs. 7(B) to 7(F), roughening the primary substrate 1 all over; forming a secondary substrate 2 by molding a resin mask 3 to be integral with the primary substrate 1 in such a manner that the area on the primary substrate 1 being applied with a conductive layer which forms a specific circuit pattern is exposed, and other area is covered by the resin mask 3; applying a catalyst for electroless plating to a circuit-forming area 11 exposed on the secondary substrate 2, removing the resin mask 3 from the secondary substrate 2 after the catalyst is applied, and forming a conductive layer 50 by electroless plating on the area having the catalyst. Details about each step are substantially same as the conventional example described above with reference to Fig. 7.

The characteristics of the present invention is, as shown in Fig. 1, that it includes a level difference between the circuit forming area 11 and the non-circuit forming area 12 of the primary substrate 1. In order to make the secondary substrate 2, the resin mask 3 is formed to be integral with the primary substrate 1 in such a manner that the area on the primary substrate 1 being applied with the conductive layer 50 which forms a specific circuit pattern (see Fig. 7(F)), which is the circuit forming area 11, is exposed, and the other area, which is the non-circuit forming area 12, is covered by the resin mask 3.

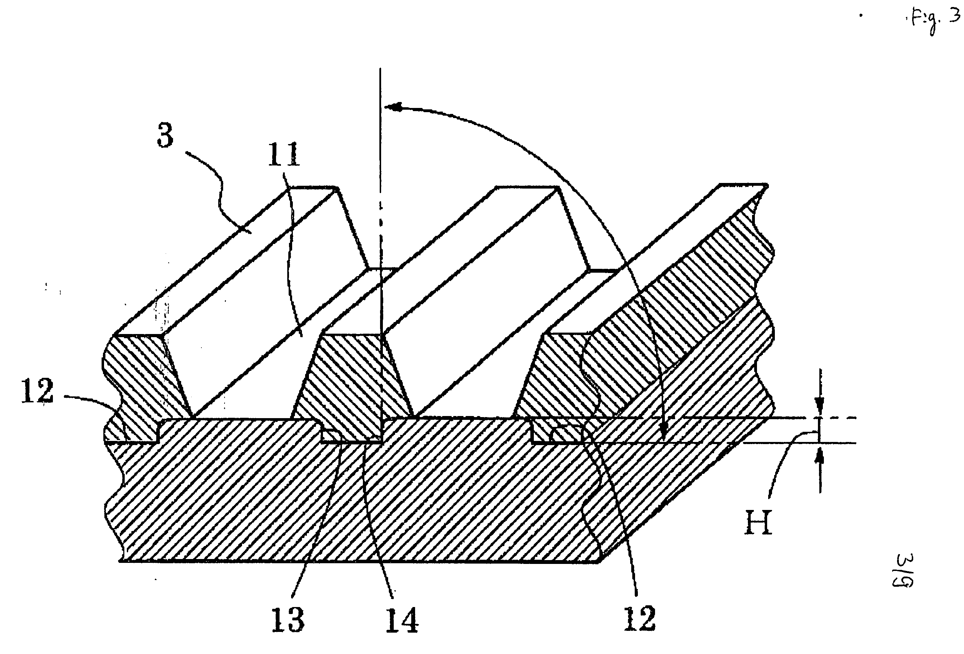

The level difference between the circuit forming area 11 and the non-circuit forming area 12 on the primary substrate 1 is dented or projecting and makes one higher or lower than the other. The level difference H is, as shown in Fig. 3, 0.05 mm, preferably 0.05 mm or more. The side walls 13 and 14 connecting the circuit forming area 11 and the non-circuit forming area 12 on the different levels is formed with a predetermined angle, and the angle is from 15° to 90°, preferably from 45° to 90°. The reason is as follows: if the angle is 15° or less, the catalyst solution 40 generates into the non-circuit forming area, with high possibility, just like the conventional example wherein the circuit forming area 10b and the non-circuit forming area 10c on the primary substrate 10 are on the same level. On the other hand, if the angle is 90° or more, the molded secondary substrate 2 may be difficult to be removed from the die assembly.

### Example 1

Example 1 according to the present invention is illustrated below with reference to Figs. 1 to Fig. 3. The primary substrate 1 shown in Fig. 1 was formed by injection molding of the liquid crystal polymer, "VECTRA C820". The circuit forming area 11 is projecting and the non-circuit forming area 12 is dented. The level difference H between them is 0.05 mm, and the side walls 13 and 14 connecting the circuit forming area and the non-circuit forming area have an angle of 90°. The surface of the primary substrate 1 was roughened with a caustic soda solution.

The resin mask 3 was formed by injection molding in such a manner that the circuit forming area 11 to have the conductive layer 50 is exposed and the dented non-circuit forming area 12 is covered. The lower edges of the both sides of the resin mask overlaps the ends of the both sides of the circuit forming area 11 by about 0.05 mm. The resin mask 3 is made of the above-described polyvinyl alcohol resin, "ECOMATY AX-2000" manufactured by Nippon Synthetic Chemical Industry Co., Ltd.

In order to apply a catalyst, the secondary substrate 2 was immersed in a bath containing a palladium catalyst solution having a depth of 500 mm, for 5 minutes at a liquid temperature of 40°C. Thereafter, the secondary substrate 2 covered with the resin mask 3 was immersed in hot water at 70°C for 60 minutes, and the hot water was stirred to dissolve the resin mask for removal. Subsequently, the circuit forming area 11 was subjected to electroless plating to form the conductive layer 50, and thus the molded circuit component was finished.

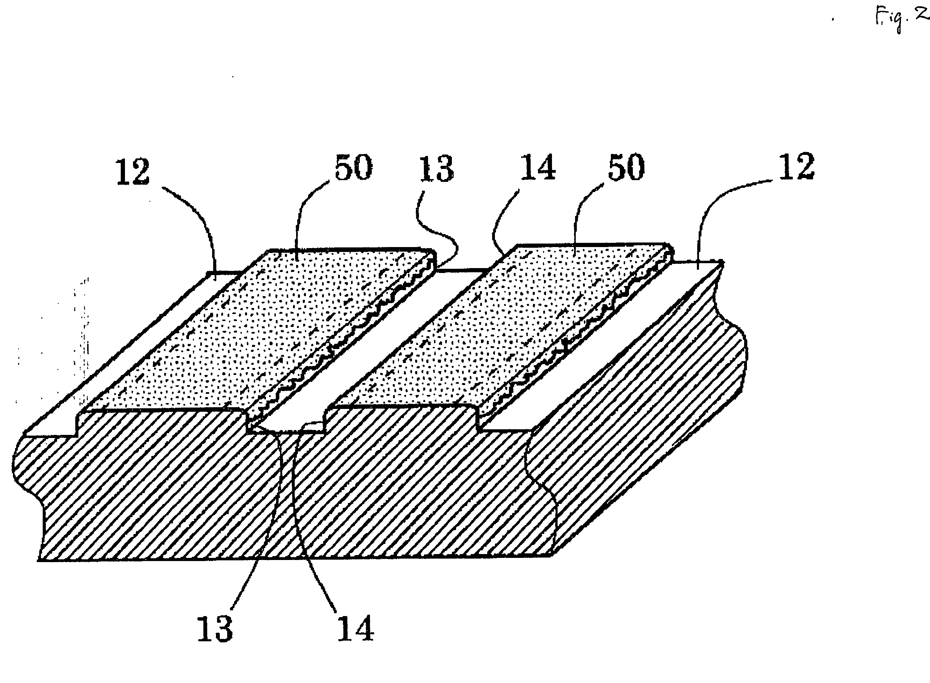

As a result of this, as shown in Fig. 2, generation of the catalyst was stopped at the portion within the widened bottom surface of the resin mask, namely within the side walls 13 and 14 located between the projecting circuit forming area 11 and the dented non-circuit forming area 12. Accordingly, shorting problem between the conductive layers 50, or shorting problem between circuits was completely prevented.

The dimensions of the circuit are listed below.
Distance between circuits: 0.5 mm
Width of circuit: 0.2 mm
Width of non-circuit area: 0.2 mm
Level difference between the circuit forming area and the non-circuit forming area: 0.05 mm
Extended creepage distance: 0.05 mm (one side)
Angle of side walls to the circuit forming area: 90° Comparative Example

When the circuit forming area 10b and the non-circuit forming area 10c of the primary substrate 10 were on the same level as seen in conventional examples, penetration of the catalyst solution occurred as shown in Fig. 9 during immersion of the substrate in a bath containing the solution having depth of 500 mm as Example 1, and shorting problem between circuits occurred in the step of formation of the conductive layer by electroless plating.

### Example 2

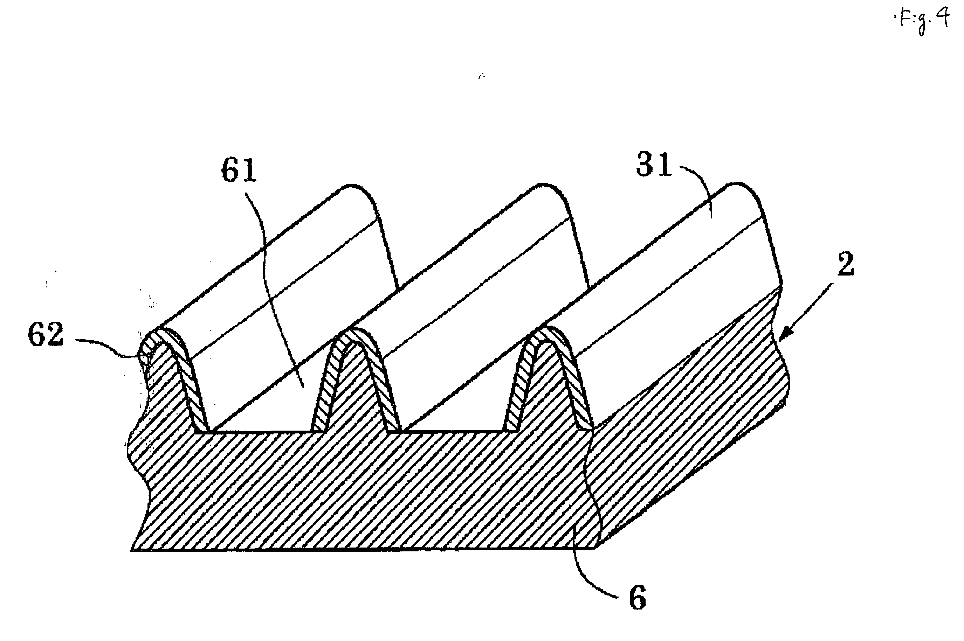

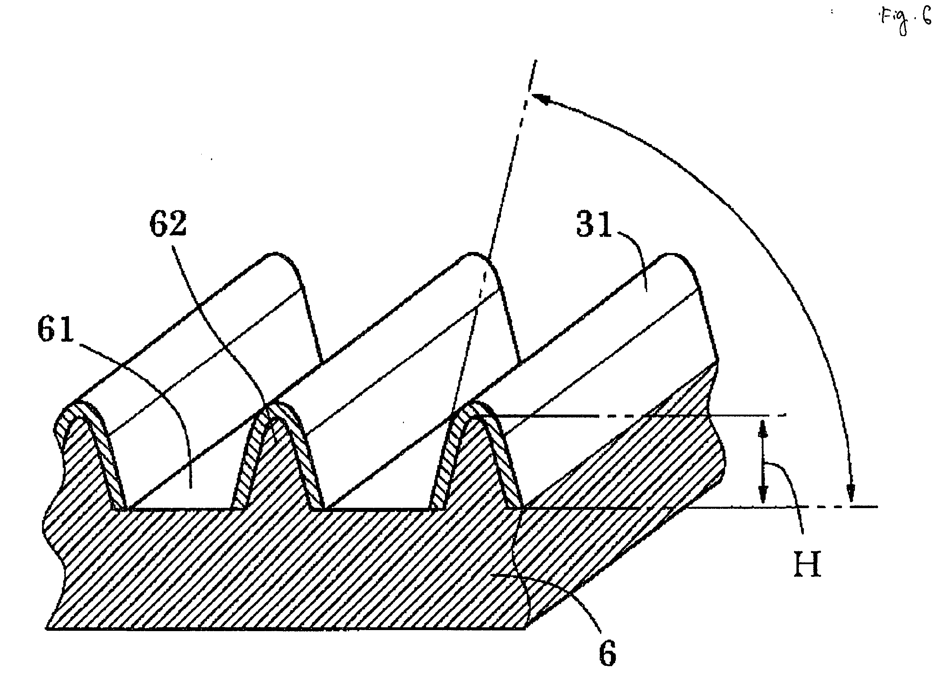

Example 2 according to the present invention is illustrated below with reference to Figs. 4 to Fig. 6. The primary substrate 6 shown in Fig. 4 was formed by injection molding of the above-described liquid crystal polymer, "VECTRA C820". The circuit forming area 61 is dented and the non-circuit forming area 62 is projecting. As shown in Fig. 6, the level difference H between them is 0.2 mm, and the inclination of the non-circuit forming portion is 80°. The surface of the primary substrate 6 was roughened with caustic soda solution.

The resin mask 31 was formed by injection molding in such a manner that the circuit forming area 61 being applied with the conductive layer 50 is exposed and the projecting non-circuit forming area 62 is covered. The lower edges of the both sides of the resin mask contacted with and overlaped the ends of the both sides of the circuit forming area 11, and then formed the secondary substrate 2. The resin mask 31 is made of the polyvinyl alcohol resin, "ECOMATY AX-2000" manufactured by Nippon Synthetic Chemical Industry Co., Ltd.

In order to apply a catalyst, the secondary substrate 2 was immersed in a bath containing a palladium catalyst solution having a depth of 500 mm for 5 minutes at a liquid temperature of 40°C. Thereafter, the secondary substrate covered with the resin mask 31 was immersed in hot water at 70°C for 60 minutes, and the hot water was stirred to dissolve the resin mask for removal. Subsequently, the circuit forming area 61 was subjected to electroless plating, and thus the molded circuit component was completed.

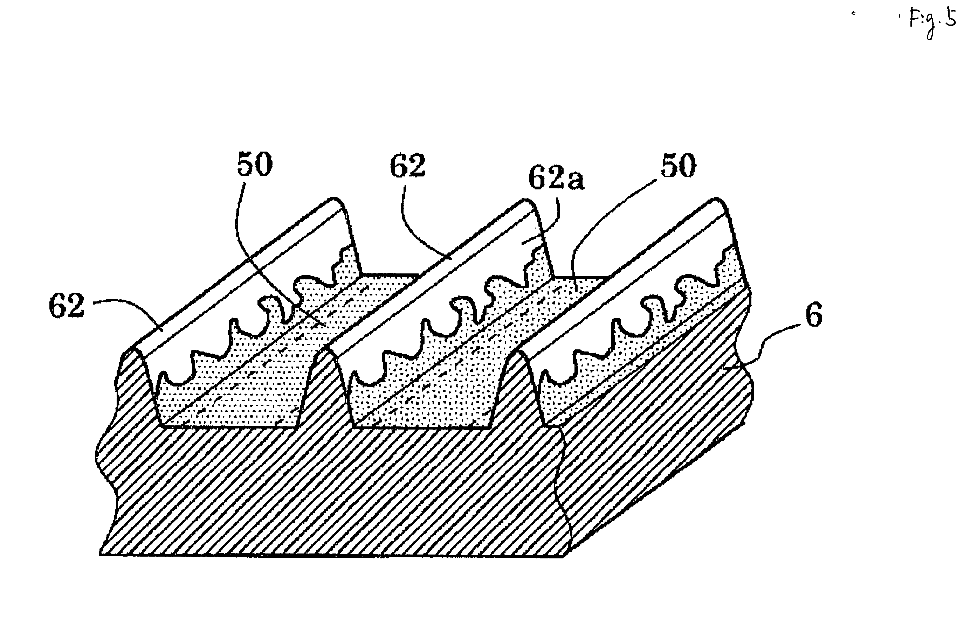

As a result of this, as shown in Fig. 5, penetration of the catalyst was stopped at the portion within a long distance between the top and bottom of the side wall 62a located between the dented circuit forming area 61 and the projecting non-circuit forming area 62. Accordingly, shorting problem between the conductive layers 50, or shorting problem between circuits was completely prevented.

The dimensions of the circuit are listed below.
Distance between circuits: 0.4 mm
Width of circuit: 0.2 mm
Width of non-circuit area: 0.2 mm
Level difference between the circuit forming area and the non-circuit forming area: 0.2 mm
Extended distance: 0.2 mm (one side)
Angle of side walls to the circuit forming area: 80°

### Industrial Applicability

The present invention is applicable to, for example, formation of circuits by plating a portion of the surface or the inner circumference of through holes of connector components for cellular telephones.

## Claims

1. A process for producing a molded circuit component comprising steps of:
injection-molding a thermoplastic material to mold a primary substrate (1) which is an insulating circuit forming body having a specified shape;
roughening the primary substrate all over;
forming a secondary substrate (2) by molding a resin mask (3) to be integral with the primary substrate (1) in such a manner that the area of the primary substrate (1) being applied with a conductive layer (11; 50) which forms a specific circuit pattern is exposed, and other area of said primary substrate (1) is covered by the resin mask (3);
applying a catalyst for electroless plating to the exposed circuit forming portion of the secondary substrate;
removing the resin mask after applying the catalyst; and
forming a conductive layer by electroless plating on the area having the catalyst, wherein
the circuit forming area (11; 50) and the non-circuit forming area (12) on the primary substrate (1) are on the different levels and lower edges of both sides of the resin mask (3) contact with and overlap the ends of both sides of the circuit forming area (11; 50).

2. The process of claim 1 for producing a molded circuit component, wherein the circuit forming area is dented and the non-circuit forming area is projecting.

3. The process of claim 1 or 2 for producing a molded circuit component, wherein the level difference between the circuit forming area and the non-circuit forming area is 0.05 mm or more.

4. The process of claim 2 for producing a molded circuit component, wherein the side walls connecting the circuit forming area and the non-circuit forming area have predetermined angle of 15° to 90°.

## Patentansprüche

1. Prozess zum Herstellen einer formgegossenen Schaltungskomponente, der die folgenden Schritte umfasst:
Spritzgießen eines thermoplastischen Materials, um ein primäres Substrat (1) formzugießen, das ein isolierender Schaltungsbildungskörper mit einer bestimmten Form ist;
Aufrauen des gesamten primären Substrats;
Bilden eines sekundären Substrats (2) durch Formgießen einer Harzmaske (3), damit es mit dem primären Substrat (1) einteilig ausgebildet ist, derart, dass der Bereich des primären Substrats (1), auf den eine leitende Schicht (11, 50) aufgebracht ist, die ein bestimmtes Schaltungsmuster bildet, freiliegt und ein weiterer Bereich des primären Substrats (1) durch die Harzmaske (3) abgedeckt ist;
Aufbringen eines Katalysators für stromloses Plattieren auf den freiliegenden Schaltungsbildabschnitt des sekundären Substrats;
Entfernen der Harzmaske nach dem Aufbringen des Katalysators; und
Bilden einer leitenden Schicht durch stromloses Plattieren auf dem Bereich, der den Katalysator aufweist, wobei
der Schaltungsbildungsbereich (11; 50) und der Bereich (12), der keine Schaltung bildet, auf dem primären Substrat (1) auf verschiedenen Höhen liegen und untere Kanten beider Seiten der Harzmaske (3) mit Enden beider Seiten des Schaltungsbildungsbereichs (11; 50) in Kontakt sind und mit diesen überlappen.

2. Prozess nach Anspruch 1, um eine gegossene Schaltungskomponente herzustellen, wobei der Schaltungsbildungsbereich vertieft ist und derBereich, der keine Schaltung bildet, vorsteht.

3. Prozess nach Anspruch 1 oder 2 zum Herstellen einer gegossenen Schaltungskomponente, wobei der Höhenunterschied zwischen dem Schaltungsbildungsbereich und dem Bereich, der keine Schaltung bildet, 0,05 mm oder mehr beträgt.

4. Prozess nach Anspruch 2 zum Herstellen einer gegossenen Schaltungskomponente, wobei die Seitenwände, die den Schaltungsbildungsbereich mit dem Bereich, der keine Schaltung bildet, verbinden, einen vorgegebenen Winkel im Bereich von 15° bis 90° haben.

## Revendications

1. Procédé pour produire un composant de circuit moulé, comprenant les étapes consistant à :
mouler par injection une matière thermoplastique pour mouler un substrat primaire (1) qui est un corps de formation de circuit isolant ayant une forme spécifiée ;
rendre le substrat primaire rugueux sur toute sa surface ;
former un substrat secondaire (2) en moulant un masque de résine (3) de manière intégrée avec le substrat primaire (1) de manière telle que la zone du substrat primaire (1) sur laquelle est appliquée une couche conductrice (11 ; 50) qui forme un motif de circuit spécifique est exposée, et d'autres zones dudit substrat primaire (1) sont couvertes par le masque de résine (3) ;
appliquer un catalyseur pour plaquage non galvanique sur la portion de formation de circuit exposé du substrat secondaire ;
supprimer le masque de résine après avoir appliqué le catalyseur ; et former une couche conductrice par placage non galvanique sur la zone ayant le catalyseur, dans lequel
la zone de formation de circuit (11 ; 50) et la zone de non-formation de circuit (12) sur le substrat primaire (1) sont à des niveaux différents et des bordures inférieures des deux côtés du masque de résine (3) viennent en contact avec et chevauchent les extrémités des deux côtés de la zone de formation de circuit (11 ; 50).

2. Procédé selon la revendication 1 pour produire un composant de circuit moulé, dans lequel la zone de formation de circuit est en creux et la zone de non-formation de circuit est en projection.

3. Procédé selon la revendication 1 ou 2 pour produire un composant de circuit moulé, dans lequel la différence de niveau entre la zone de formation de circuit et la zone de non-formation de circuit est de 0,05 mm ou plus.

4. Procédé selon la revendication 2 pour produire un composant de circuit moulé, dans lequel les parois latérales qui connectent la zone de formation de circuit et la zone de non-formation de circuit ont un angle prédéterminé de 15° à 90°.
